Europäisches Patentamt

European Patent Office

Office européen des brevets

(19)

(11) EP 0 892 092 B1

(12) EUROPEAN PATENT SPECIFICATION

(45) Date of publication and mention
of the grant of the patent:
01.10.2003 Bulletin 2003/40

(51) Int Cl.[7]: C30B 31/00, C30B 33/00,
C30B 29/04

(21) Application number: 97305317.6

(22) Date of filing: 16.07.1997

(54) **Surface enriched diamond**

Diamant mit einer angereicherten Oberfläche

Diamant à surface enrichie

(84) Designated Contracting States:
BE DE ES FR GB IE IT

(43) Date of publication of application:
20.01.1999 Bulletin 1999/03

(73) Proprietor: GENERAL ELECTRIC COMPANY
Schenectady, NY 12345 (US)

(72) Inventors:
• D'Evelyn, Mark P.
Niskayuna, New York 12309 (US)
• Park, Dong-Sil
Niskayuna, New York 12309 (US)
• Anthony, Thomas Richard
Schenectady, New York 12309-2514 (US)
• Spiro, Clifford Lawrence
Niskayuna, New York 12309 (US)
• Meng, Yue
Columbus, Ohio 43235 (US)

(74) Representative: Szary, Anne Catherine, Dr. et al
London Patent Operation,
GE International, Inc.,
Essex House,
12-13 Essex Street
London WC2R 3AA (GB)

(56) References cited:
EP-A- 0 668 377          US-A- 4 184 079
US-A- 5 523 071

• POPOVICI G ET AL: "DIFFUSION OF BORON,
LITHIUM, OXYGEN, HYDROGEN, AND
NITROGEN IN TYPE LLA NATURAL DIAMOND"
JOURNAL OF APPLIED PHYSICS, vol. 77, no. 10,
15 May 1995, pages 5103-5106, XP000543587

• SU WENHUI ET AL: "An investigation of the
distribution of boron atoms in the aggregate
crystals of diamond containing boron" XTH
AIRAPT. INTERNATIONAL HIGH PRESSURE
CONFERENCE. PROCEEDINGS OF THE XTH
AIRAPT INTERNATIONAL HIGH PRESSURE
CONFERENCE ON RESEARCH IN HIGH
PRESSURE SCIENCE AND TECHNOLOGY,
AMSTERDAM, NETHERLANDS, 8-11 JULY 1985,
vol. 139B+C, no. 1-3 & vol.140B+C, no.1-3, ISSN
0378-4363, PHYSICA B & C, MAY 1986,
NETHERLANDS, pages 654-657, XP002041129

• POPOVICI G ET AL: "Diffusion of impurities
under bias in CVD diamond films" DIAMOND,
SIC AND NITRIDE WIDE BANDGAP
SEMICONDUCTORS. SYMPOSIUM, DIAMOND,
SIC AND NITRIDE WIDE BANDGAP
SEMICONDUCTORS. SYMPOSIUM, SAN
FRANCISCO, CA, USA, APRIL-AUG. 1994, 1994,
PITTSBURGH, PA, USA, MATER. RES. SOC,
USA, pages 601-606, XP002041321

• ANDERSON G C ET AL: "The effect of carbon
and nitrogen implantation on the abrasion
resistance of type IIa (110) diamond" EIGHTH
INTERNATIONAL CONFERENCE ON ION BEAM
MODIFICATION OF MATERIALS, HEIDELBERG,
GERMANY, 7-11 SEPT. 1992, vol. B80-81, pt.2,
ISSN 0168-583X, NUCLEAR INSTRUMENTS &
METHODS IN PHYSICS RESEARCH, SECTION B
(BEAM INTERACTIONS WITH MATERIALS AND
ATOMS), JUNE 1993, NETHERLANDS, pages
1451-1455, XP002041151

EP 0 892 092 B1

**Description**

This invention is related to diamond composition and article, grown at high temperature and pressure with increased compressive fracture strength (CFS). More particularly, this invention relates to inhomogeneously incorporation of selected elements towards and/or near the outer surface of the diamond crystal to increase its fracture strength and performance. The invention also relates to method of making the diamond crystals that are surface enriched with elements that increase the compressive fracture strength.

Diamond crystals are typically used for the production of diamond tools such as grinding wheels, dressing or truing tools for grinding wheels, and saw blades.

To function effectively in the above-mentioned applications, diamond crystals having the highest strength, including compressive fracture strength, are desirable. The compressive fracture strength is a key specification for diamond crystals, and is often correlated with the diamond's performance in such applications. Crystal fracture strength, as measured by Roll Crusher, correlates with performance of diamond in these applications, such as stone cutting.

The compressive fracture strength may be measured by compressively fracturing a population of diamond grains both before and after treatment. The Roll Crusher method utilizes an apparatus having a pair of hard counter-rotating rollers adapted with a means to measure the compressive force applied by the rollers to grains passing between the rollers at the moment of grain fracture. The motion of one of the rollers is measured by a suitable transducer such as a linear voltage differential transformer to generate an electric signal proportional in voltage to the deflection of the roller and hence proportional to the compressive force on the diamond grain.

Diamond is a brittle solid and fails by fracture. Its elastic constant (Young's modulus, of diamond) is high, $1.143 \times 10^{12}$ Gigapascals. The ductile-brittle transition temperature for diamond is about $1150°C$. The above applications use diamond in the brittle fracture region extending from room temperature to about $1000°C$.

Impurity atoms dissolved in the diamond crystal, such as boron, nitrogen, and hydrogen, can generate stresses because of the large lattice dilations that they cause. For example, dissolved nitrogen, boron, and hydrogen atoms expand the diamond lattice around them by 40%, 33.7%, and 31%, respectively. If the distribution of dissolved nitrogen, boron, or hydrogen is uniform in a diamond crystal, the lattice just expands uniformly and no long-range stresses develop. However, if the distribution of nitrogen, boron, or hydrogen is not uniform, inhomogeneous strains will occur in the diamond. These uneven strains will generate large long-range stresses.

Presently, the impurity concentration in synthetic diamond crystals decreases with increasing radius within the diamond crystal. There are several reasons for this. For instance, in the High Pressure High Temperature (HPHT) process used to synthesize diamond crystals, the concentration of nitrogen in the melt decreases with time since the growing diamond takes up nitrogen from the melt. (Melt refers to the molten, metallic catalyst/solvent through which carbon is transported from the graphite feedstock to the growing diamond crystals at high pressure and high temperature.) Another reason is that the growth rate of the diamond crystal is decreasing with increasing radius and the impurity incorporation decreases with decreasing growth rate. Further, the impurity concentration in the diamond crystal may depend on the growth sector. By growth sector is meant the crystallographic direction in which growth took place (or is taking place), and the region(s) in the crystal in which growth occurred in the same direction.

This decreasing impurity concentration with increasing radius (i.e., negative concentration gradient) causes tangential tensile stresses on the surface of the diamond. Since diamond is a brittle solid, its compressive fracture strength is reduced by these tangential tensile stresses.

As technology advances, the next generation of diamonds will require higher strength. Thus, there is a need for a diamond crystal with increased compressive fracture strength. There is also a need for methods to manufacture these diamond crystals.

Popovici et al "Diffusion of boron, lithium, oxygen, hydrogen and nitrogen in a type IIa natural diamond" Journal of Applied Physics, vol 77, no 10, 15 May 1995, pages 5103-5106 describes a two step diffusion process. First diffusion of lithium and oxygen was performed in a nitrogen atmosphere at $860°C$ for one hour. The sample was then placed in a hot filament CVD growth reactor and diffusion was performed for two hours in a hydrogen atmosphere from a boron solid source placed on the surface of the sample.

SUMMARY OF THE INVENTION

In accordance with these needs, this invention comprises an element-doped diamond crystal having an increased compressive fracture strength wherein the concentration of doping-element impurities increases between the center and the surface of the diamond crystal, thereby generating tangential compressive stresses at the surface of the diamond crystal. The invention also is a diamond crystal which comprises an element-doped diamond crystal having an increased compressive fracture strength with a positive doping-element concentration gradient between the center and the surface of the diamond crystal that generates tangential compressive stresses at the surface of the diamond crystal. Examples of doping elements may include, but are not limited to, boron, nitrogen, hydrogen, lithium, nickel, cobalt, sodium, potassium, aluminum, phosphorous, and oxygen. Herein, element-doped may also be referred to as an impurity atom, impurity element, or impurity concentration. Other examples of impurities are interstitials and vacancies in the crystalline structure, including carbon interstitials.

Another aspect of the invention includes articles of manufacture, such as saws, grinding wheels, and stone cutting tools, containing the diamond crystal of this invention. Still another aspect of this invention are methods for making the diamond crystal having increased compressive fracture strength.

An inhomogeneous concentration or distribution of impurities can be generated either by differential incorporation of impurities within different crystal growth sectors or by temporal changes in growth conditions which generate radial impurity gradients. Since growth conditions control the distribution of impurities in the diamond, diamonds of this invention can be strengthened by different growth conditions.

It is an object of the present invention to increase the compressive fracture strength of synthetic diamond, such as diamond grit used in tools.

It is an object of the present invention to increase the compressive fracture strength of synthetic diamond by having an elevated concentration of impurity atoms in the diamond or near its surface.

Another object of the present invention is to provide methods for increasing the compressive fracture strength in synthetic diamond crystals.

Other objects of the present invention will become apparent from the following drawings and description.

BRIEF DESCRIPTION OF THE DRAWINGS

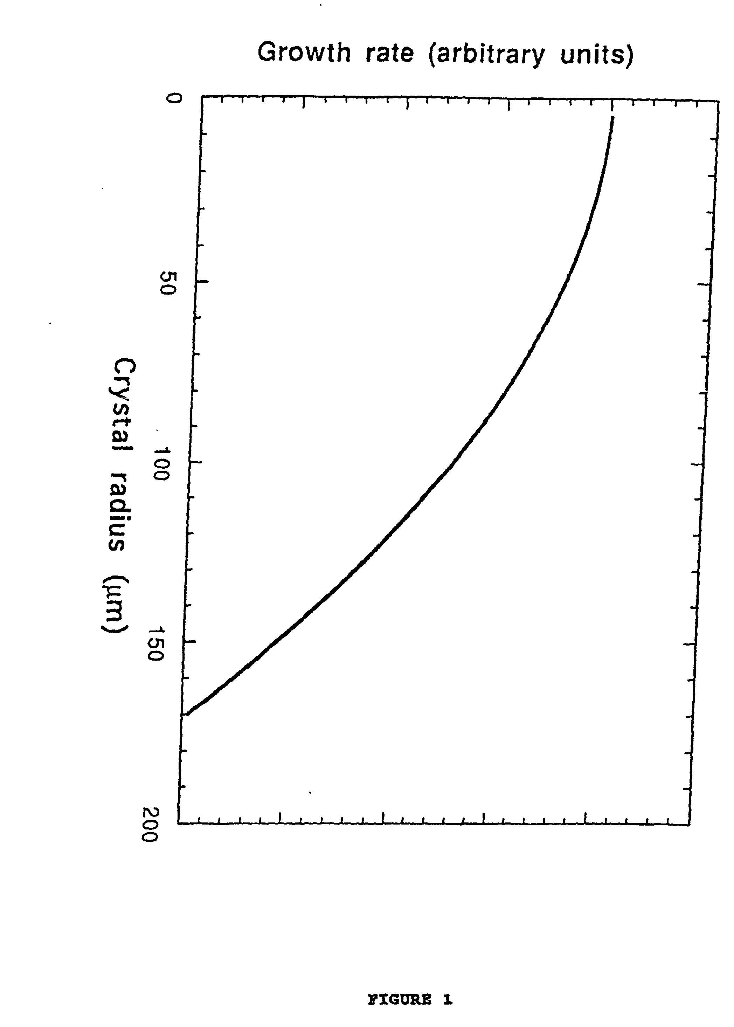

FIG. 1 is a plot of the growth rate versus the diamond crystal radius for the prior art.

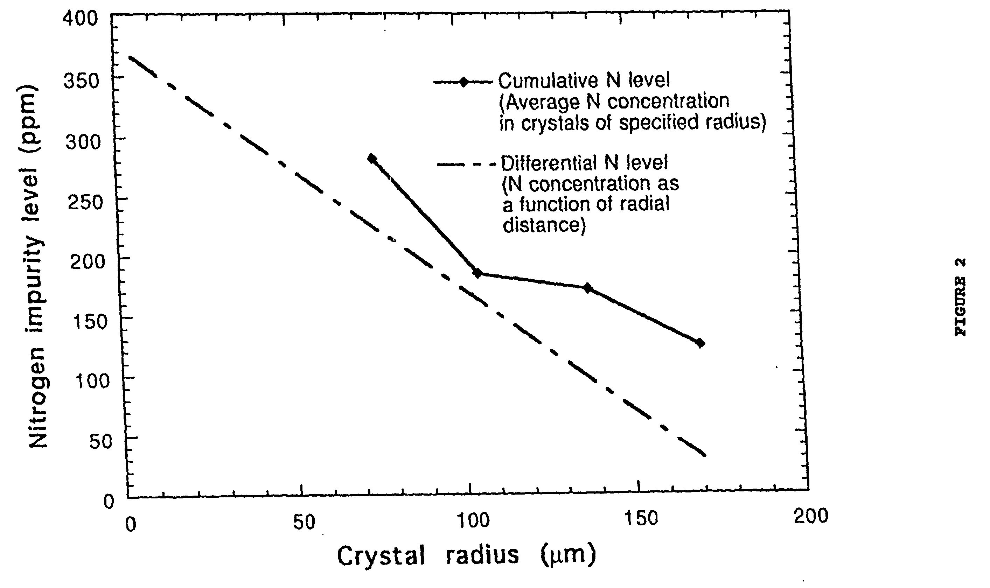

FIG. 2, also showing the prior art, depicts a plot of nitrogen impurity level in parts per million (ppm) versus the diamond crystal radius.

FIG. 3, representing the prior art, is the plastic yield stress (solid line) of diamond versus temperature. The diamond-graphite equilibrium line (dashed line) is also shown.

FIG. 4, representing the prior art, is the radial, tangential and shear stresses in a diamond with a negative linear radial gradient of impurities.

FIG. 5, demonstrating this invention, is the radial, tangential and shear stresses in a diamond with a positive linear radial gradient of impurities.

FIG. 6, demonstrating this invention, *is* the radial, tangential and shear stresses in a diamond with a thin shell of impurities contiguous to the outer surface of the diamond.

FIG. 7 is a photomicrograph of a (111) crystal facet on a diamond crystal of this invention having an impurity doped coating on the surface of the diamond.

FIG. 8 is a photomicrograph of a (100) crystal facet on a diamond crystal of this invention having an impurity coating on the surface of the diamond.

FIG. 9 is a photomicrograph of a cross-section of the coating thickness of the diamond of this invention.

DESCRIPTION OF THE INVENTION

It has been discovered that a positive radial gradient (i.e., increasing concentration with increasing radius), of an impurity element that causes an expansion of the diamond lattice, will produce tangential compressive stresses at the diamond surface that strengthen the diamond in the same manner as tempered glass. Ideal candidates for the impurity or doping element include boron, nitrogen, hydrogen, lithium, nickel, cobalt, sodium, potassium, aluminum, phosphorous, and oxygen. Also, interstitials and vacancies in the crystal may be considered impurities, including carbon interstitials. Boron, hydrogen, and nitrogen readily incorporate into diamond during growth. Boron provides an additional advantage of enhanced oxidation resistance. In this invention, nitrogen can have a local concentration of 0-1000 parts per million; hydrogen can have a concentration of 0-1000 parts per million; and there can be a mixture of boron, nitrogen and hydrogen with a concentration of 0-10,000 parts per million.

Natural isotopic abundance diamond is comprised of two carbon isotopes, namely 98.9% $^{12}C$ carbon and 1.1% $^{13}C$ carbon. More than 1.1% of carbon isotope $^{13}C$ can be considered an impurity in natural isotopic abundance diamond. The $^{13}C$ isotope causes a contraction of the diamond latttice. Therefore, a negative concentration gradient of $^{13}C$ isotope is produced in a diamond crystal, and compressive tangential stresses will be developed at the surface of the diamond causing the diamond to be strengthened.

The diamond crystal utilized in the invention is a synthetic diamond made by a High Pressure High Temperature process wherein pressures greater than about 45 kilobar are combined with temperatures exceeding 1200 degrees Centigrade in the carbon P-T region where diamond is the thermodynamically preferred phase. A variety of diamond crystals can be produced.

It is also contemplated that the process of the present invention is suitable for use with a variety of starting diamond crystals (also referred to as grains). The commercially available diamond abrasive grains are available at various strengths and toughness. Variations in growth rate during manufacture is one factor that may be utilized to control the properties of the diamond abrasive grain. A perfect diamond crystal is likely to have more regular cleavage and wear. Crystal faults, twinning, etc. may occur and lead to variations in the diamond crystalline properties.

The starting diamond crystals preferably have uncoated surfaces. It is intended that the process of the present invention be utilized to increase the compressive fracture strength of the diamond prior to subsequent attachment to a tool. By way of example, a diamond crystal of this invention is at least nominally a single crystal, but also may have one or more twin planes present. It is a three dimensional (3-D) faceted diamond crystal. The diameter of the diamond crystal is up to and including about two centimeters in diameter (2cm). The diamond crystal has an impurity concentration that increases with increasing radius leading to a compressive tangential stress at the surface of the crystal. In one manifestation of this invention, the impurities are at a local maximum at the surface of the crystal, decreasing with smaller radii to a local minimum at least about 5 micrometers below the surface of the diamond crystal. The impurity concentration within the outermost 0.25-50 micrometers is 10-10,000 parts per million. Also, this invention includes a 3-D diamond crystal in which one component (i.e., the tangential component) of the stress state of some of the facet surfaces of the crystal is compressive in the range of 10-5000 MegaPascals (MPa). The tangential compressive surface stresses is up to and including 5000 MPa. The radial surface stress is always 0 MPa. Also, the compressive tangential stresses on the diamond crystal of this invention can be superimposed on existing tensile tangential stresses on the crystal. The range of superimposed compressive tangential stresses on preexisting tensile tangential stesses in the diamond crystal is 10-5000 MPa.

Herein, the invention will be demonstrated by using boron, nitrogen and hydrogen. Because of the extremely high binding energy and atomic density of diamond, boron, nitrogen and hydrogen can dissolve to an appreciable extent in diamond. Even in the cases of boron, nitrogen and hydrogen, the solubility is limited and amounts to less than a few hundred parts per million for nitrogen, and less than 1% for boron. Despite their limited solubilities in diamond, dissolved nitrogen, boron or hydrogen can generate stresses because of the large lattice dilations that they cause. If the distribution of nitrogen, boron or hydrogen is not uniform, inhomogeneous strains will occur in the diamond. These uneven strains will generate large long-range stresses. A rough estimate of the magnitude of these stresses can be found by multiplying the Young's modulus of diamond ($10^{12}$ Pascals) by the strain generated by an impurity. For nitrogen in diamond, the maximum strain occurs at the maximum solubility of nitrogen in diamond and is of the order of 4.5 X $10^{-4}$. This amount of strain will result in a stress of the magnitude of 5 X $10^8$ Pascals. This compares with experimental diamond crushing strengths of 0.2 --> 2 X $10^{10}$ Pascals. Thus, stresses generated by nonuniform distributions of nitrogen in diamond can be *as* high as *2.5% to* 25% of the crushing strength of diamond.

Uneven distribution of nitrogen or boron in diamonds can arise from two different sources. The first source of an inhomogeneous distribution of boron or nitrogen is the variation of the distribution coefficient (the ratio between the solubility of an impurity in the liquid and the solid phase) of boron and nitrogen with the diamond crystal growth facet. For example, nitrogen incorporation typically is greatest in the (111) growth sector, slightly less in (100) growth sector, and still less in (113) and (110) sectors. The nitrogen concentration is commonly as high as several hundred parts per million. If a section is made through the center of a typical synthetic diamond crystal, the cross section will typically exhibit both (111) and (100) growth sectors. The greater lattice expansion caused by nitrogen in the (111) growth sectors is incompatible with the lower lattice expansion in the low nitrogen (100) sector. These incompatible strains generate tensile stresses in the (100) growth sector and compressive stresses in the (111) growth sector. The tensile stresses in the (100) sector may weaken the diamond crystal in mechanical grinding and sawing applications.

Boron also has a distribution coefficient that is dependent on the crystal growth *facet* of diamond. In the higher concentrations of boron that are of interest, boron is preferentially incorporated in the (111) sector in both gem diamonds and CVD diamond. Boron causes the diamond lattice to expand by 33.7% and its solubility in diamond can be as much as 0.9%. Thus, the incorporation of boron will also lead to stresses in a diamond crystal in a similar manner to that of nitrogen. For boron in diamond, the maximum strain occurs at the maximum solubility of boron in diamond and is of the order of 3 X $10^{-3}$. This amount of strain can result in a stress of the magnitude of 3.4 X $10^9$ Pascals which is significant in comparison to the experimental diamond crushing strengths of 0.2 --> 2 X $10^{10}$ Pascals. Thus, stresses generated by nonuniform distributions of boron in diamond can be as high as 17% to 170% of the crushing strength of diamond.

A second source of an inhomogeneous distribution of boron or nitrogen in a diamond crystal arises from changes in the growth-cell conditions occurring during crystal growth. Temporal changes in the pressure, the temperature, the concentration of impurity in the melt and/or the crystal growth rate can change the amount of boron or nitrogen incorporated in the crystal as a function of time. Inhomogenities arising from such causes will lead to radial impurity concentration gradients in the crystal. The stresses resulting from such radial concentration gradients suggests possible ways to toughen a diamond crystal by suitable changes in the growth-cell conditions during crystal growth.

To achieve an analytic solution, approximate the faceted soccer-ball shape of an equiaxed diamond crystal by a diamond sphere. This is actually a reasonably good approximation to the highest quality diamond grit whose shape approaches that of a sphere. In addition, consider in detail only the case where the impurity concentration gradients are solely a function of the radial distance R from the center of the diamond crystal.

The mechanical equilibrium of any small spherical element demands a balance between the differential radial forces on the opposing faces of the element. If $\phi$ is the angle subtended in both tangential directions by the spherical element, $\sigma_r$ is the radial stress, $\sigma_t$ is the tangential stress and R is the radius of the spherical element, then a balance of radial forces requires:

$$[(R + dR)d\phi]^2 \, [\sigma_r + \frac{d\sigma_r}{dR} \, dR] - (Rd\phi)^2 \, \sigma_r = 2 \, [R \, d\phi \, dR]$$

$$\sigma_t \, d\phi \tag{1}$$

which reduces to equation 2 as dR and $d\phi$ approach zero.

$$\frac{d\sigma_r}{dR} + \frac{2 \, (\sigma_r - \sigma_t)}{R} = 0 \tag{2}$$

Strains in the diamond are caused by stresses and by the presence of impurities that cause expansion or contraction of the diamond lattice. The strain $\varepsilon_i$ caused by an impurity is given by:

$$\varepsilon_i = \alpha \, C \tag{3}$$

where $\alpha$ is a constant dependent on the impurity and C is the atomic concentration of the impurity in the lattice. For nitrogen, boron and hydrogen in diamond, $\alpha = 0.4$, 0.337 and 0.31, respectively.

The stresses developed in the diamond are related to the strains by Hooke's Law

$$\sigma_r - 2 \, v \, \sigma_t = E \, ( \, \varepsilon_r - \varepsilon_i \, ) \tag{4a}$$

$$\sigma_t - v \, ( \, \sigma_t + \sigma_r ) = E \, ( \, \varepsilon_t - \varepsilon_i ) \tag{4b}$$

where v is Poisson's ratio and E is Young's modulus for diamond and $\varepsilon_r$ is the radial strain and $\varepsilon_t$ is the tangential strain. The impurity strain $\varepsilon_i$ in equations 4a and 4b is subtracted from the elastic strains $\varepsilon_r$ and $\varepsilon_t$, respectively, because the impurity strain is not supported by elastic stresses but instead is generated by changes in the lattice size caused by an over or under sized impurity atom. The commonly accepted value of Poisson's ratio for diamond is 0.07. The orientation averaged Young's modulus for diamond is 1.143 X $10^{12}$ N/m$^2$.

Equations 4a and 4b can be solved for the radial $\sigma_r$ and tangential stresses at.

$$\sigma_r = \frac{E}{(1+v) \, (1-2v)} \, [ \, (1-v) \, \varepsilon_r + 2v \, \varepsilon_t - (1+v)\alpha C] \tag{5a}$$

$$\sigma_t = \frac{E}{(1+v) \, (1-2v)} \, [ \, v \, \varepsilon_r + \varepsilon_t - (1-v)\alpha C] \tag{5b}$$

The radial $\varepsilon_r$ and tangential strains $\varepsilon_t$ can be expressed in terms of the radial displacement u.

$$\varepsilon_r = \frac{du}{dR} \tag{6a}$$

$$\varepsilon_t = \frac{u}{R} \tag{6b}$$

Equations 6a and 6b are substituted into Equations 5a and 5b and then into Equation 2 to give:

$$\frac{d^2u}{dR^2} + \frac{2}{R}\frac{du}{dR} - \frac{2u}{R^2} = \frac{(1+v)}{(1-v)}\alpha\frac{dC}{dR} \tag{7a}$$

or

$$\frac{d}{dR}\left[\frac{1}{R^2}\frac{d}{dR}(R^2 u)\right] = \frac{(1+v)}{(1-v)}\alpha\frac{dC}{dR} \tag{7b}$$

which is Laplace's Equation in spherical co-ordinates.
Integration of Equation 7b gives the displacement u(R):

$$u(R) = \frac{(1+v)}{(1-v)}\alpha\frac{1}{R^2}\int_0^R C(r)\ r^2\ dr + A\ R + \frac{B}{R^2} \tag{8}$$

where A and B are constants of integration and C(r) is the concentration of nitrogen or boron in the diamond as a function of the radius. For a solid sphere of diamond by symmetry, the displacement u -> 0 as R -> 0 so that B = 0. Equation 8 can be substituted back into Equations 6a, 6b, 5a and 5b to find the radial and tangential stresses in the diamond.

$$\sigma_r(R) = -\frac{(2\ \alpha E)}{(1-v)}\frac{1}{R^3}\int_0^R C(r)\ r^2\ dr + \frac{E\ A}{(1-2v)} \tag{9a}$$

$$\sigma_t(R) = \setminus F(\alpha E, (1-v))\ \setminus F(1, R^3)\int_0^R C(r)\ r^2\ dr +$$
$$\frac{E\ A}{(1-2v)} - \frac{\alpha E\ C(R)}{(1-v)} \tag{9b}$$

The radial stress $\sigma_r$ at the outer free surface ($\sigma_r$=0 at R=S) of the diamond must be zero ($\sigma_r$=0 at R=S) so from Equation 9a the constant A is found to be:

$$A = \frac{2\ \alpha\ (1-2v)}{(1-v)}\frac{1}{S^3}\int_0^S C(r)\ r^2\ dr \tag{10}$$

where S is the radius of the diamond. Introduction of the constant A in equations 9a and 9b yields:

$$\sigma_r(R) = \frac{2\ \alpha E}{(1-v)} \left[ \frac{1}{S^3} \int_0^S C(r)\ r^2\ dr \quad - \quad \frac{1}{R^3} \int_0^R C(r)\ r^2\ dr \right] \qquad (10a)$$

$$\sigma_t(R) = \frac{\alpha E}{(1-v)} \left[ \frac{2}{S^3} \int_0^S C(r)\ r^2\ dr \quad + \quad \frac{1}{R^3} \int_0^R C(r)\ r^2\ dr \quad - \quad C(R) \right] \qquad (10b)$$

Equation 10a has an interesting physical interpretation. The radial stress is proportional to the difference between the average impurity concentration in the entire diamond (the first integral of equation 10a) and the average impurity concentration in the diamond within the radius R of interest (the second integral of equation 10a). If the average concentration within a radius of R is greater than the average impurity concentration for the entire diamond, the radial stress will be compressive for an impurity that expands the lattice.

The three cases demonstrated are a radially increasing concentration of impurity, a radially decreasing concentration of impurity, and a thin shell of impurities. These different impurity distributions will generate different stress states in the diamond crystal and may strengthen the crystal.

The following discussion is related to the stresses that develop in a diamond crystal with particular radial distributions of impurities.

The first case of interest is where the concentration of impurity increases linearly with the radius, i.e., $C(r) = C_o\,r/S$ from $r = 0$ to $r = S$. Substitution into equations 10a and 10b yields:

$$\sigma_r(R) = \frac{\alpha E C_o}{2(1-v)} \left[\, 1 - R/S \,\right] \qquad (11a)$$

$$\sigma_t(R) = \frac{\alpha E C_o}{4(1-v)} \left[\, 2 - 3R/S \,\right] \qquad (11b)$$

The following is the case where $\alpha$ is positive; that is, the impurity causes an expansion of the diamond lattice. The radial stress is tensile, i.e. positive, and a maximum at the center of the diamond and decreases linearly to zero at the surface of the diamond. The tangential stresses are also a maximum at the center of the diamond and are also tensile there. However, at a radius equal to 2/3 the radius of the diamond, the tangential stresses pass through zero and thereafter become compressive stresses, i.e., negative, and reach a maximum compression state at the surface of the diamond. These tangential compressive stresses at the surface of the diamond will make the diamond less likely to fail in tension and fracture and therefore toughen the diamond crystal.

The case where the impurity causes a contraction of the diamond lattice ( $\alpha < 0$ ) just reverses the signs of the stresses so that the radial stress is compressive and at an absolute maximum at the center and decreases linearly to zero from the center to the surface of the diamond. The tangential stresses are also compressive and at an absolute maximum at the center of the crystal. At a radius of 2/3 the radius of the diamond, the tangential stresses change from compressive to tensile and reach a maximum at the surface of the diamond. These tangential tensile stresses at the surface of the diamond may weaken the diamond by making it more susceptible to tensile failure and fracture from minor scratches.

Shear stresses can also cause a diamond to fail particularly at higher temperatures where the shear yield strength rapidly decreases with increasing temperature. The maximum shear stress $\sigma_s$ in a diamond with a radial type of concentration gradient is given by one-half the difference between the radial stress $\sigma_r$ and the tangential stress $\sigma_t$.

$$\sigma_s(R) = 1/2 \, [\sigma_r(R) - \sigma_t(R)] = \frac{\alpha E C_o}{8(1-v)} \, R/S \qquad (12)$$

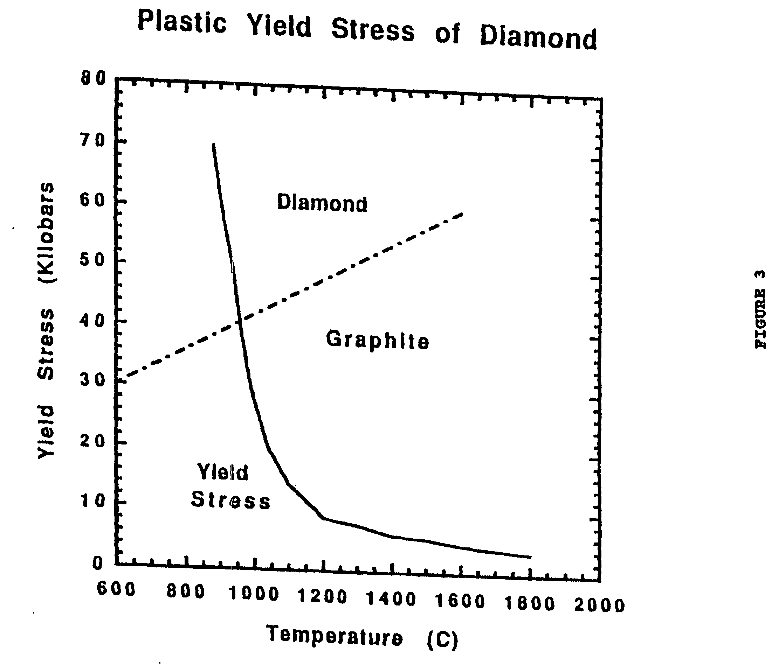

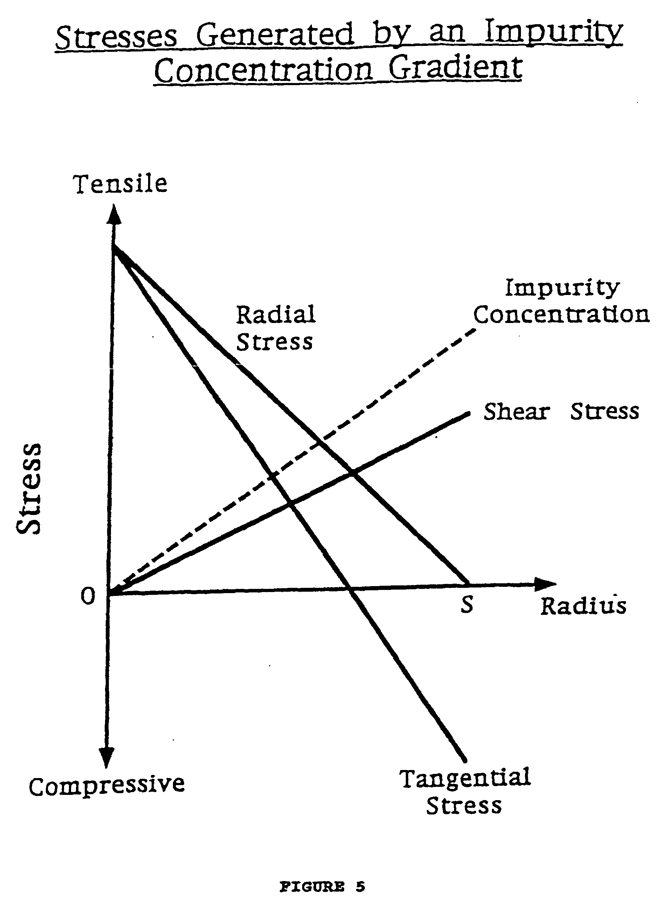

Note that the shear stress increases with the radius and reaches a maximum at the surface of the diamond. Diamond will fail when the shear stress exceeds the shear yield stress K of diamond, as shown in Figure 3, which is dependent on the crystallographic direction, crystallographic plane and temperature. The concentration of impurities and the radial, tensile and shear stresses are plotted as a function of the radius in Figure 5 for the case where an impurity like boron or nitrogen expands the diamond lattice.

A second case of interest (demonstrating the prior art) is where the concentration of impurity decreases linearly with the radius, i.e., $C(r) = C_o \, (1 - r/S)$ from r = 0 to r = S. Substitution into equations 10a and 10b yields:

$$\sigma_r(R) = - \frac{\alpha E C_o}{2(1-v)} \, [\, 1 - R/S \,] \qquad (13a)$$

$$\sigma_t(R) = - \frac{\alpha E C_o}{4(1-v)} \, [\, 2 - 3R/S \,] \qquad (13b)$$

The absolute value of the stresses remain unchanged and only their signs are changed from the previous case. Since the first term in our concentration expression, $C(r) = C_o \, (1 - r/S)$, namely Co represents a uniform concentration term, it does not cause any stresses. We are then left with the -Co r/S expression which is the same concentration distribution that was used in the previous case except for its sign.

In the usual case for diamond, where $\alpha$ is positive, the impurity causes an expansion of the diamond lattice. The radial stress is compressive, i.e. negative, and a maximum at the center of the diamond and decreases linearly to zero from the center of the diamond to the surface of the diamond. The tangential stresses are also a maximum at the center of the diamond and are compressive there. However, at a radius equal to 2/3 the radius of the diamond, the tangential stresses pass through zero and thereafter become tensile stresses, i.e., positive, and reach an absolute maximum at the surface of the diamond. These tangential tensile stresses at the surface of the diamond will make the diamond more likely to fail in tension and weaken the diamond crystal by making it more susceptible to fracture.

The case where the impurity causes a contraction of the diamond lattice ( $\alpha$ < 0) just reverses the signs of the stresses so that the radial stress is tensile and at an absolute maximum at the center and decreases linearly to zero from the center to the surface of the diamond. The tangential stresses are also tensile and at an absolute maximum at the center of the crystal. At a radius of 2/3 the radius of the diamond, the tangential stresses change from tensile to compressive and reach a maximum at the surface of the diamond. These tangential compressive stresses at the surface of the diamond may strengthen the diamond by making it more resistant to tensile failure and fracture caused by surface flaws or scratches.

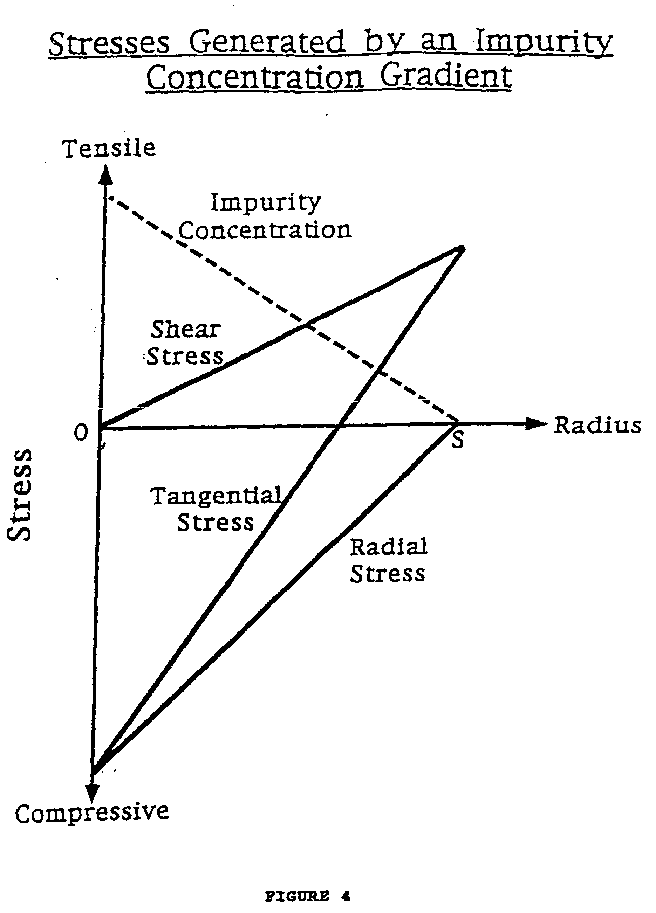

Because only the sign of the radial and tangential stresses was reversed by inverting the impurity expansion to impurity contraction, the shear stresses which are derived from the difference in the radial and tangential stresses remain the same as the previous case. For the radially decreasing concentration gradient case, the concentration of impurities and the radial, tensile and shear stresses are plotted as a function of the radius in Figure 4 (prior art) for the case where an impurity like boron or nitrogen expands the diamond lattice.

A third case of interest is where the impurity resides in a thin shell of thickness "x" adjacent to the external surface of the diamond. Such a case could arise if the diamonds were exposed to boron, nitrogen, or hydrogen at a high temperature so that the boron, nitrogen, or hydrogen diffused into a thin outer shell of the diamond crystal. Similarly, if the diamonds were exposed to a high energy plasma containing hydrogen, nitrogen, or boron, these impurities could become implanted in a thin shell contiguous to the outer surface of the diamond.

This distribution of impurities would be described mathematically as follows: for 0<R<(S-x), C=0 ; for (S-x) <R<S, $C=C_o$ where x is the thickness of the shell. Substitution into equations 10a and 10b yields for the condition of a thin shell, i.e., x << S:

$$\sigma_r(R) = \frac{2\alpha E C_o}{(1-v)} \, [\, x/S \,] \qquad : R < (S-x) \; ; \; x<<S \qquad (14a)$$

$$\sigma_r (S) = 0 \qquad : R = S \tag{14b}$$

$$\sigma_t(R) = \frac{2\alpha EC_o}{(1-v)} [\, x/S \,] \qquad : R < (S-x) \; ; \; x << S \tag{14c}$$

$$\sigma_t(S) = -\frac{\alpha EC_o}{(1-v)} [\, 1 - 3x/s \,] \qquad : R = S \; ; \; x << S \tag{14d}$$

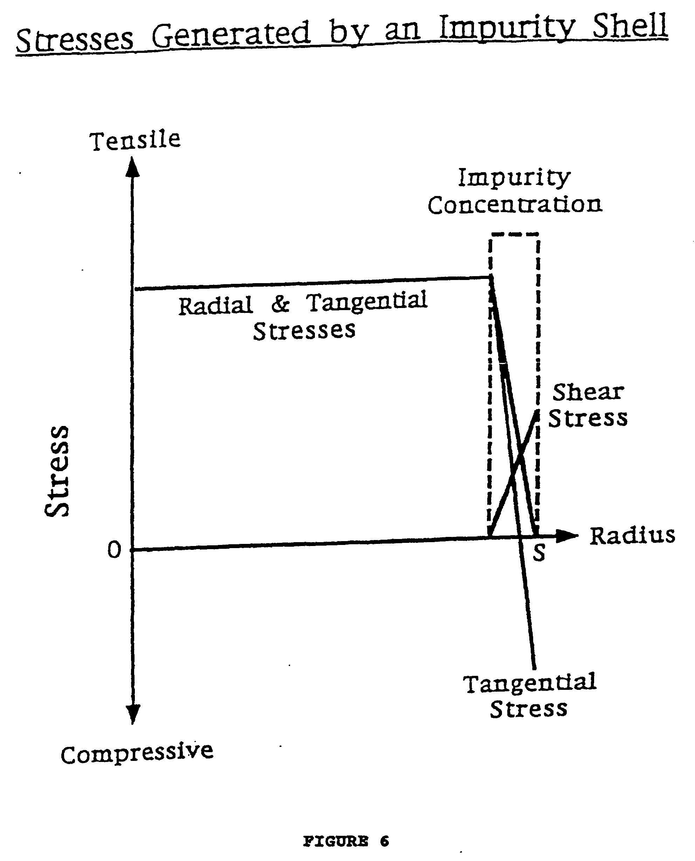

In the case where $\alpha$ is positive, that is, the impurity causes an expansion of the diamond lattice, the radial stress is a small constant tensile stress in the zone inside the diamond which is free of impurities. The radial stress rapidly decreases as the outer shell of impurities is crossed and falls to zero on the surface of the diamond as expected. The tangential stresses are also small tensile stresses in the impurity-free zone inside the diamond. However, the tangential stresses change to large compressive stresses on the surface of the diamond. This compressive stress state on the diamond surface will make the diamond more resistant to tensile failure and fracture and will thereby toughen and strengthen the diamond. Figure 6 shows the impurity concentration profile and stress distribution for a diamond crystal with a thin shell of impurities at its outer surface.

The case where the impurity causes a contraction of the diamond lattice ( $\alpha < 0$ ) just reverses the signs of the stresses. The case where a diamond containing a uniform level of impurity has a thin shell depleted of impurities contiguous to the external surface (perhaps by outdiffusion of the impurity after crystal growth) would have the same absolute stress values as Equations 14a-14d but the signs of all the stresses would be reversed.

The shear stresses $\sigma_s$ generated by a thin shell of impurities are given by the difference between the radial stress and the tangential stresses in the diamond:

$$\sigma_s (R) = 0 \qquad : R < (S-x) \; ; \; x << S \tag{15a}$$

$$\sigma_s(S) = \frac{|\alpha|EC_o}{2(1-v)} [\, 1 - 3x/S \,] \qquad : R = S \; ; \; x << S \tag{15b}$$

The shear stresses are zero inside the impurity-free region where a state of pure hydrostatic tension exists. On passing through the thin spherical shell of impurities, the shear stresses rise to a maximum at the surface of the diamond.

The rate of linear crystal growth normally decreases during the course of growth, and impurities in the growth medium normally become incorporated into the diamond throughout the run. In one method of this invention, using the High Pressure High Temperature (HPHT) process to make diamond crystals, a powdered boron source, such as boron carbide ($B_4C$), boron nitride (BN), or elemental boron, is encapsulated by carbon and added to the growth cell. Encapsulation of the boron source powder is achieved by CVD through methane pyrolysis; coating with colloidal graphite and drying; sputtering; or the like. During the early stages of diamond growth at HPHT, no boron is available to growing diamond crystals. As growth proceeds, the carbon coating dissolves into the metal solvent-catalyst, eventually exposing the boron source. At this point boron begins dissolving in the solvent-catalyst and becomes incorporated into the outer portion of the diamond crystals. The boron level and the thickness of the boron-doped layer can be controlled by varying the concentration and size of the boron-containing particles within the growth medium and the thickness of the carbon coat.

Another method is using a carbon-encapsulated nitrogen source, such as $Fe_xN$, to produce crystals with a positive nitrogen radial concentration gradient. If desired, the nitrogen level in the center portion of the crystals can be reduced by means of a getter in the growth medium, a low-porosity core, or by excluding air from the growth cell immediately prior to growth.

Another alternative method of the invention involves deposition of a boron or nitrogen-rich layer *on* lightly or undoped diamond crystals grown normally. This could be performed by using the undoped crystals as seeds in a second HPHT run, where sufficient boron, nitrogen, or boron and nitrogen is present in the growth medium to produce a doped, epitaxial layer over the crystal. This option requires a second growth run. However, since only a thin layer, 0.5 to 50 micrometers thick, is needed the number of diamond crystals in the cell could be larger than normal.

Still another method of the invention involves allowing boron, nitrogen, or hydrogen to diffuse into the diamond crystals. Other impurities can be diffused, such as oxygen, lithium, sodium, phosphorous, aluminum, nickel, cobalt, or a mixture thereof. The impurity concentration would be between 10-10,000 parts per million at depths in the diamond surface between 0.25 - 50 micrometers. A preferred depth is 0.25-10 micrometers. Impurities can be diffused by means of exposure to a plasma containing hydrogen and/or nitrogen and boron containing gases. The diffusion length of vacancies in diamond is reported as approximately 100 microns at 1100°C for an annealing time of one week. Diffusion of boron or nitrogen may be slower, but nevertheless rapid enough to achieve strengthening of the diamond crystals on a reasonable time scale. The presence of hydrogen in the gas phase may help stabilize the diamond crystals and permit extended treatment at temperatures above 1000°C without significant graphitization.

Other ways to diffuse atoms into the diamond would be by exposure to a gas containing the impurity atoms, such as hydrogen, boron, or nitrogen at temperatures between 700-1400°C for a period of 10 seconds to 100 hours. Still another way to diffuse impurity atoms into the diamond surface is to coat the diamond crystal surface with a solid or liquid film containing hydrogen, boron, or nitrogen, and then heat treating the coated crystals at a temperature between 700-1400°C for a sufficient amount of time to diffuse the impurity atoms into the outer diamond surface. This period of time is 10 seconds to 100 hours.

In an alternative method, the undoped or lightly-doped crystals could be placed in a CVD (chemical vapor deposition) reactor, and a doped, epitaxial layer grown by adding a boron or nitrogen-containing gas to the normal reactant feedstock, typically hydrogen, methane and oxygen. Deposition at a substrate temperature less than or approximately equal to 740°C would add additional intrinsic compressive stress to the doped diamond layer, and could perform the purpose of this invention even in the absence of doping. The film of doped diamond is 0.25 - 50 micrometers thick and the concentration of the doped impurity in the outer layer is greater than 10 - 10,000 parts per million of the concentration of the impurities in the outermost portion of the underlying diamond crystal.

One way that crystal growth conditions can generate stresses in a diamond crystal is the case where the pressure and temperature in the cell vary with time. If controlled in a suitable manner, such varying conditions can produce positive radial impurity concentration gradients in the diamond crystal. For impurities such as boron, nitrogen or hydrogen that expand the diamond lattice, positive radial gradients will produce a compressive stress state at the surface of the diamond that will toughen the diamond and make it more resistance to tensile fracture. Also, by increasing the growth rate of the diamond crystal as a function of the radius (time), there will be an increase in the incorporation of the concentration of impurities in the diamond. Further, by increasing the concentration of impurities in the melt with time, there will be an increasing impurity concentration versus radius.

Yet another method to achieve the diamond crystal with increased CFS of this invention is to produce swelling near the outer surface of the diamond crystals grown by the High Pressure High Temperature process (HPHT). This can be done by radiation damage by means of ion or electron bombardment. The. radiation damage causes swelling of the diamond lattice because of interstitials and vacancies, where the interstitial atoms could be either carbon atoms or an impurity atom or a combination thereof. This thin shell of lattice-expanding impurities will generate a compressive stress state at the surface of the diamond crystal and make it more resistant to fracture. In contrast to the strenghening provided by radial gradients, the protection from this thin compression shell disappears once the thin shell is penetrated by abrasion of the crystal during use. A 3-D diamond crystal whose surface has been ion implanted or subjected to radiation damage may have an impurity atom, interstitial, and vacancy concentration in the range of 1-10,000 parts per million.

Other methods for doping impurities in the outermost surface of the diamond crystal include impurities deposited in a layer by hydrothermal growth, electrochemical growth, liquid phase solid source growth, or molten salt growth.

Table 1. demonstrates the invention and the impact of impurity concentrations of nitrogen, boron, and hydrogen on the compressive fracture strength (CFS) for a diamond crystal at its outer surface.

TABLE I

| STRENGTH INCREASE FOR DIAMOND CRYSTAL WITH INHOMOGENEOUS CONCENTRATION OF IMPURITIES NEAR SURFACE | | | | | |
|---|---|---|---|---|---|
| Impurity | Maximum Concentration (ppm) | Max Tangential Stress Graded (MegaPascals) | Max Tangential Stress Thin Layer (MegaPascals) | % Increase In Strength Graded | % Increase in Strength Thin Layer |
| Nitrogen | 1,000 | 123 | 492 | 7.7% | 30.8 |
| Boron | 10,000 | 1040 | 4150 | 65% | 259% |
| Hydrogen | 1,000 | 95 | 381 | 5.9% | 23.8% |

Strength of 40/45 MBS diamond - 1.6 Gigapascals ($10^9$ Pascals)

$E_0 = 1.143 \times 10^{12}$ Pascals

$\alpha_N = 0.4$

$\alpha_\beta = 0.337$

$\alpha_H = 0.31$

$v = 0.07$

$1-v = 0.93$

$E_0 / (1,v) = 1.23 \times 10^{12}$ Pascals

$E_0/4(1-V) = 3.07 \times 10^{12}$ Pascals

The following examples further serve to illustrate the invention.

**Example I.**

The starting material was commercial GE Superabrasives MBS 970 crystals (product of General Electric Company) in 45/50 mesh size, grown according to the HPHT process, known to those skilled in the art. The nitrogen distribution in the untreated crystals shows a tensile tangential stress at the surface of approximately 50 MPa, weakening the crystals. The compressive fracture strength (CFS) of the untreated crystals was measured by roll-crusher apparatus as 28.8 Kg (63.5 lbs).

The nitrogen (N) concentration was measured as 4.2 ppm on the (100) crystal facet by Secondary Ion Mass Spectrometry (SIMS) (not an absolute value). The nitrogen (N) concentration was measured as 29.5 ppm on the (111) crystal facet by SIMS (not an absolute value). The SIMS signals were converted to concentrations using ion-implanted diamond standards. However, ion implantation causes lattice damage and likely affects the sensitivity. Comparison of the SIMS data with nitrogen concentrations determined by combustion analysis (LECO) of whole crystals indicates that the SIMS-determined concentrations are too low by a factor of 2-4.

The diamond crystals were then placed on a substrate inside a microwave plasma chemical vapor deposition (CVD) reactor. The flow rate was 1000 sccm hydrogen ($H_2$), 5 sccm methane, 10 sccm nitrogen ($N_2$). The pressure was about 9.33 KPa (70 torr); the substrate temperature was between about 700-750°C and the microwave power was about 3 Kilowatts. The diamond crystals were coated for 3 hours. The coating growth was interrupted to roll the crystals around and then the coating deposition was repeated for another 3 hours to achieve uniform coating.

The thickness of the nitrogen-doped CVD diamond layer was about 5 micrometers. The compressive fracture strength (CFS) of the coated crystals was measured by a roll-crusher apparatus at 29.9 Kg (65.9 lbs), an increase of 3.8%. The nitrogen concentration in the diamond layer on the (100) face of the coated crystals was measured by SIMS as 62.5 ppm (not an absolute value). The nitrogen (N) concentration on the (111) face of the coated crystals was measured by SIMS as 79.5.

Using the average surface concentrations measured by SIMS, the theoretical model of the present invention predicts that the coating generated a compressive tangential stress of 26.6 MPa, resulting in an increase in fracture strength of 1.7%. However, scaling the SIMS-determined surface nitrogen concentrations by a factor of 2-4, as mentioned above, would predict a strength increase of 3.4-6.8%, in excellent agreement with the measured value of 3.8%.

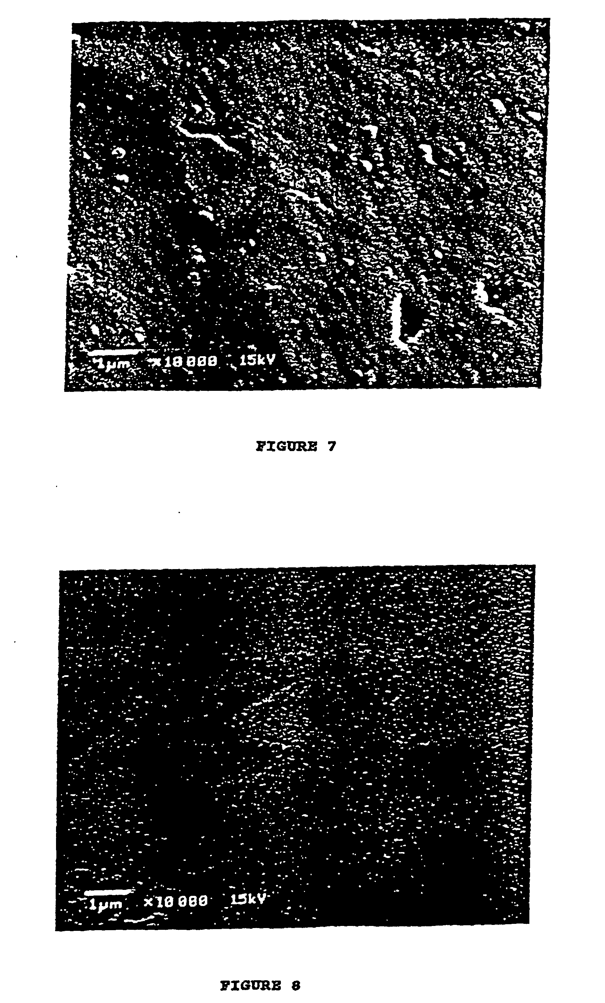

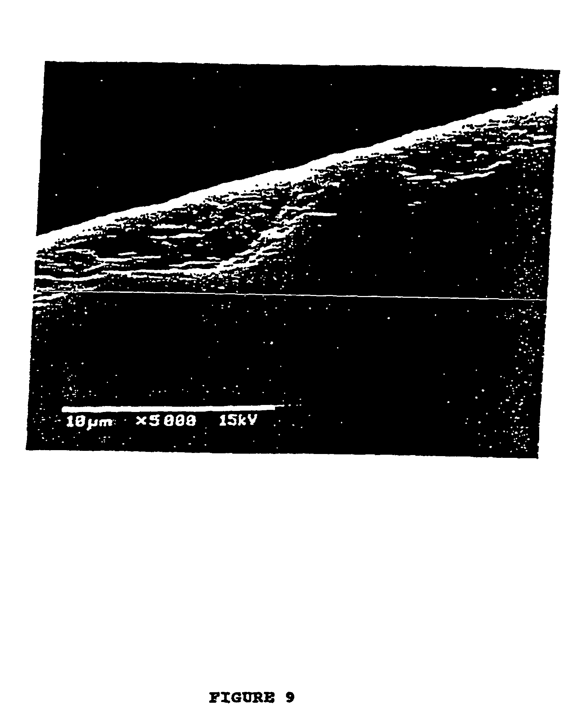

Pock marks, surface roughness (see Figs. 7 and 8), unevenness of coated layer (also see Fig. 9) gives somewhat lower strengthening than calculated.

**Example II.**

The starting material was commercial GE Superabrasives MBS 970 crystals (product of General Electric Company) in 45/50 mesh size, grown according to the HPHT process, known to those skilled in the art. The nitrogen distribution in the untreated crystals shows a tensile tangential stress at the surface of approximately 50 MPa, weakening the crystals. The compressive fracture strength (CFS) of the untreated crystals was measured by roll-crusher apparatus as 32.0 Kg (70.6 lbs).

The diamond crystals were then placed on a substrate inside a microwave plasma chemical vapor deposition (CVD) reactor. The flow rate was 900 sccm hydrogen ($H_2$). The pressure was about 100 torr; the substrate temperature was between about 700-900°C and the microwave power was about 3 Kilowatts. The diamond crystals were exposed to the hydrogen plasma for 2 hours. The hydrogen plasma process was interrupted to roll the crystals around and then the hydrogen plasma process was repeated two times for 2 additional hours each time to achieve uniform exposure of the crystals to the hydrogen plasma.

Compressive fracture strength (CFS) of coated crystals was measured by roll-crusher apparatus as 34.3 Kg (75.7 lbs), an increase of 7.2%.

Based on literature reports of hydrogen incorporation into diamond by means of hydrogen plasma treatments [M.I. Landstrass et al., Appl. Phys. Lett. 55, 975 (1989); T. Maki et al., Jpn. J. Appl. Phys. 31, L1446 (1992); G. Popovici et al., J. Appl. Phys. 77, 5103 (1995)], the surface hydrogen concentration is estimated to be as high as 1000 ppm. The theoretical model of the present invention predicts the surprising result that the in-diffused hydrogen atoms will generate a compressive tangential stress as high as 380 MPa, resulting in an increase in fracture strength of 24%. The observed strength increase is well within this range.

## Claims

1. A diamond crystal obtained by a high temperature high pressure process which comprises an element-doped diamond crystal having an increased compressive fracture strength with a positive doping element concentration gradient near the surface of the diamond crystal, where the dopant-element concentration in the diamond crystal is within an outermost 0.25-50 micrometers of the diamond crystal in an amount of 10-10,000 parts per million, and said doping-element causes an expansion of the diamond lattice, that generates tangential compressive stresses at the surface of the diamond crystal.

2. A diamond crystal according to claim 1 where the dopant elements are selected from the group consisting of boron, nitrogen, hydrogen, lithium, nickel, cobalt, sodium, potassium, aluminum, phosphorous, oxygen, and mixtures thereof.

3. A diamond crystal according to claim 1 where there are impurities that include interstitials, carbon interstitials and vacancies in the crystal.

4. A diamond crystal according to claim 1 wherein the concentration of doping-element impurities increases between the center and the surface of the diamond crystal.

5. A diamond crystal according to claim 1 in the form of a three-dimensional faceted diamond crystal having a diameter up to and including two centimeters; containing impurities where said impurities have a greater concentration toward or near an outermost surface of said crystal than in a center of said crystal, so that said impurity concentration increases as a function of a radius within said crystal; and a tangential compressive stress at a surface of said crystal up to and including 5000 megapascals.

6. A three-dimensional faceted diamond crystal according to claim 5 having a coated film of doped diamond 0.25-50 micrometers thick on an outer surface of said diamond crystal, wherein a concentration of impurities in the coated film is present in a greater amount of 10-10,000 parts per million that the concentration of impurities in the outer surface of said underlying diamond crystal.

7. A three-dimensional faceted diamond crystal according to claim 5 with a surface having undergone ion implanatation or radiation treatment such that the concentration of impurities is in a range of 10-10,000parts per million.

8. A three-dimensional faceted diamond crystal according to claim 5 where a range of superimposed tangential compressive stresses of 10-5000 Megapascals on preexisting tangential tensile stresses in said diamond crystal.

9. A method of making a diamond crystal having a tangential compressive stress on a surface up to 5000 Megapascals and having a positive doping element concentration gradient near the surface of the diamond, comprising the step of:

   growing a three dimensional diamond crystal by a High Temperature High Pressure process having impurities that enrich an-outer surface of said crystal in a concentration that is 10-10,000 parts per million at a depth from the outer surface of 0.25-50 micrometers and a diameter up to two centimeters.

EP 0 892 092 B1

10. A method to produce a diamond having improved compressive fracture strength and having a positive doping element concentration gradient near the surface of the diamond comprising the steps of:

forming a three-dimensional faceted diamond crystal up to two centimeters in diameter by a high temperature high pressure process, and

depositing impurities in an outermost surface of said diamond crystal to a depth between 0.25-50 micrometers from said surface in an amount of 10-10,000 parts per million to produce a tangential compressive stress up to and including 5000 megapascals on at least one facet of said crystal.

11. A method to produce a diamond having improved compressive fracture strength according to claim 10 where radiation produces swelling the outermost surface of said diamond by ion or electron bombardment to provide interstitials, carbon interstitials, and vacancies.

12. A method to produce a diamond having improved compressive fracture strength according to claim 10 where the diamond crystal is grown by High Pressure High Temperature process and said diamond is further grown a second time with the High Pressure High Temperature process to deposit a layer of diamond doped with impurities in an outermost surface.

13. A method to produce a diamond having improved compressive fracture strength according to claim 10 where said impurities are deposited in a layer by hydrothermal growth, electrochemical growth, liquid phase solid source growth, or molten salt growth.


**Patentansprüche**

1. Ein durch ein Verfahren bei hoher Temperatur und hohem Druck hergestellter Diamantkristall, der einen mit einem Element dotierten Diamantkristall umfasst, der sich durch eine erhöhte Bruchspannung bei Druck mit einem bzgl. des Dotierungselements positiven Konzentrationsgradienten nahe der Oberfläche des Diamantkristalls auszeichnet, wo die Konzentration des Dotierungselements im Kristall innerhalb der äußersten 0.25-50 µm des Diamantkristalls 10-10,000 ppm beträgt und das Dotierungselement eine Aufweitung des Diamantgitters bewirkt, so dass eine tangentiale Druckbeanspruchung an der Oberfläche des Diamantkristalls erzeugt wird.

2. Ein Diamantkristall gemäß Anspruch 1, wobei die zur Dotierung verwendeten Elemente aus einer Gruppe bestehend aus Bor, Stickstoff, Wasserstoff, Lithium, Nickel, Cobalt, Natrium, Kalium, Aluminium, Phosphor, Sauerstoff und Mischungen davon ausgewählt werden.

3. Ein Diamantkristall gemäß Anspruch 1, wobei es Fremdatome gibt, die Zwischengitterplätze, Kohlenstoffzwischenräume und Leerstellen im Kristall einschließen.

4. Ein Diamantkristall gemäß Anspruch 1, in dem die Konzentration der durch die Dotierungselemente eingelagerten Fremdatome vom Kern zur Oberfläche des Kristalls hin ansteigt.

5. Ein Diamantkristall gemäß Anspruch 1 in Form eines dreidimensionalen facettierten Diamantkristalls, der einen Durchmesser bis zu und einschließlich 2 cm aufweist und der Fremdatome enthält, wobei die Fremdatome in Richtung oder nahe der äußersten Oberfläche des Kristalls höher konzentriert sind als im Kern des Kristalls, so dass die Konzentration der Fremdatome als eine Funktion des Radius innerhalb des Kristalls zunimmt; und eine tangentiale Druckspannung an der Oberfläche des Kristalls bis zu und einschließlich 5000 MegaPascal verursacht.

6. Ein dreidimensional facettierter Diamantkristall gemäß Anspruch 5, der mit einer 0.25-50 µm dicken Schicht des dotierten Diamanten an der äußersten Oberfläche des besagten Diamantkristalls belegt ist, wobei eine Konzentration der Fremdatome in dieser Schicht mit 10-10,000 ppm höher ist als die Konzentration an Fremdatomen an der äußeren Oberfläche des darunter liegenden Diamantkristalls.

7. Ein dreidimensional facettierter Diamantkristall gemäß Anspruch 5, mit einer Oberfläche, die einer Ionenimplantierung oder -bestrahlung unterzogen wurde, so dass die Konzentration an Fremdatomen im Bereich von 10 -10,000 ppm liegt.

13

**8.** Ein dreidimensional facettierter Diamantkristall gemäß Anspruch 5, in dem eine Reihe von überlagerten tangentialen Druckspannungen von 10-5000 Megapascal die bereits vorhandenen Zugspannungen im Diamantkristall.

**9.** Ein Verfahren zur Herstellung von Diamantkristallen, die eine tangentiale Druckspannung an der Oberfläche bis zu 5000 MegaPascal und eine bzgl. des dotierten Elements positiven Konzentrationsgradienten nahe der Oberfläche des Diamanten aufweisen, umfassend folgenden Schritt:

Wachstum eines dreidimensionalen Diamantkristalls unter hoher Temperatur und hohem Druck bis zu einem Durchmesser von 2 cm in Gegenwart von Fremdatomen, die sich an der äußeren Oberfläche des Kristalls in einer Konzentration von 10-10,000 ppm bis zu einer Tiefe von der äußeren Oberfläche von 0.25-50 μm anreichern.

**10.** Ein Verfahren zur Herstellung eines Diamanten, der eine verbesserte Bruchspannung unter Druck und eine bzgl. des dotierten Elements positiven Konzentrationsgradienten nahe der Oberfläche des Diamanten aufweist, umfassend die folgenden Schritte:

- Aufbau eines dreidimensionalen facettierten Diamantkristalls bis zu einem Durchmesser von 2 cm durch einen Hochtemperatur- und Hochdruckprozess und
- Abscheidung von Fremdatomen an der äußersten Oberfläche des Diamantkristalls bis zu einer Tiefe von 0.25-50 μm von der Oberfläche in einer Menge von 10-10,000 ppm zur Erzeugung einer tangentiale Druckspannung bis einschließlich 5000 Megapascal auf mindestens einer Facettenfläche des Kristalls.

**11.** Ein Verfahren zur Herstellung eines Diamanten, der eine verbesserte Bruchspannung unter Druck gemäß Anspruch 10 aufweist, wobei die Bestrahlung durch Ionen- oder Elektronenbeschuss zur Erzeugung von Zwischengitterplätzen, Kohlenstoffzwischenräume und Leerstellen im Kristall zu einem Anschwellen der äußersten Oberfläche des besagten Diamanten führt.

**12.** Ein Verfahren zur Herstellung eines Diamanten, der eine verbesserte Bruchspannung unter Druck gemäß Anspruch 10 aufweist, wo der Diamantkristall in einem Hochdruck- und Hochtemperaturprozess gewachsen ist und ein zweites Mal unter Hochdruck und Hochtemperatur einem Wachstumsprozess unterworfen wird, um eine Schicht von Diamant dotiert mit Fremdatomen in einer äußersten Oberfläche abzulagern.

**13.** Ein Verfahren zur Herstellung eines Diamanten, der eine verbesserte Bruchspannung unter Druck gemäß Anspruch 10 aufweist, wo die besagten Fremdatome in einer Schicht durch hydrothermales oder elektrochemisches Wachstum oder durch Wachstum in der flüssigen Phase initiiert durch Impfkristalle (liquid phase solid source) oder Wachstum aus der Salzschmelze abgeschieden werden.

**Revendications**

**1.** Cristal de diamant obtenu par un processus haute température haute pression, comprenant un cristal de diamant dopé par élément, doté d'une résistance accrue à la rupture par compression et d'un gradient positif de concentration d'élément dopant au voisinage de la surface du cristal de diamant, dans lequel la concentration d'élément dopant dans le cristal de diamant, dans une couche superficielle épaisse de 0,25 à 50 micromètres du cristal de diamant, vaut de 10 à 10.000 parties par million, et ledit élément dopant provoque une dilatation du réseau du diamant qui engendre des contraintes tangentielles de compression à la surface du cristal de diamant.

**2.** Cristal de diamant selon la revendication 1, dans lequel les éléments dopants sont choisis dans l'ensemble comprenant le bore, l'azote, l'hydrogène, le lithium, le nickel, le cobalt, le sodium, le potassium, l'aluminium, le phosphore, l'oxygène et des mélanges de ceux-ci.

**3.** Cristal de diamant selon la revendication 1, dans lequel il y a des impuretés qui comprennent des éléments interstitiels, des atomes de carbone interstitiels et des lacunes dans le cristal.

**4.** Cristal de diamant selon la revendication 1, dans lequel la concentration des impuretés éléments dopants augmente entre le centre et la surface du cristal de diamant.

**5.** Cristal de diamant selon la revendication 1, se présentant sous la forme d'un cristal de diamant facetté tridimensionnel dont le diamètre peut atteindre deux centimètres et qui contient des impuretés, lesquelles impuretés se trouvent en concentration plus forte vers ou près de la surface externe dudit cristal qu'au centre dudit cristal, si bien que ladite concentration des impuretés augmente en fonction du rayon au sein dudit cristal, la contrainte tangentielle de compression à la surface dudit cristal pouvant atteindre 5000 mégapascals.

6. Cristal de diamant facetté tridimensionnel selon la revendication 5, doté d'un film de revêtement de diamant dopé, épais de 0,25 à 50 micromètres, sur une surface externe dudit cristal de diamant, dans lequel les impuretés se trouvent, dans le film de revêtement, en une concentration de 10 à 10.000 parties par million, plus grande que la concentration d'impuretés à la surface externe dudit cristal de diamant sous-jacent.

7. Cristal de diamant facetté tridimensionnel selon la revendication 5, dont une surface a subi un traitement par implantation d'ions ou irradiation, tel que la concentration d'impuretés se situe dans l'intervalle de 10 à 10.000 parties par million.

8. Cristal de diamant facetté tridimensionnel selon la revendication 5, dans lequel des contraintes tangentielles de compression de 10 à 5000 mégapascals se superposent aux contraintes tangentielles de traction préexistantes dans ledit cristal de diamant

9. Procédé de fabrication d'un cristal de diamant, présentant une contrainte tangentielle de compression pouvant aller jusqu'à 5000 mégapascals sur une surface et doté d'un gradient positif de concentration d'élément dopant au voisinage de la surface du diamant, comprenant l'étape consistant :

à faire croître, par un processus haute température haute pression, un cristal de diamant tridimensionnel dont une surface externe est enrichie en impuretés, présentes en une concentration de 10 à 10.000 parties par million à une profondeur de 0,25 à 50 micromètres à compter de la surface externe, et qui a un diamètre pouvant aller jusqu'à deux centimètres.

10. Procédé de fabrication d'un diamant doté d'une résistance améliorée à la rupture par compression et doté d'un gradient positif de concentration d'élément dopant au voisinage de la surface du diamant, comprenant les étapes suivantes :

formation d'un cristal de diamant facetté tridimensionnel qui peut avoir jusqu'à deux centimètres de diamètre, par un processus haute température haute pression ;
et dépôt d'impuretés dans une couche superficielle dudit cristal de diamant, jusqu'à une profondeur de 0,25 à 50 micromètres à compter de ladite surface, en une concentration de 10 à 10.000 parties par million, en vue de produire une contrainte tangentielle de compression pouvant aller jusqu'à 5000 mégapascals sur au moins une facette dudit cristal.

11. Procédé de fabrication d'un diamant doté d'une résistance améliorée à la rupture par compression, selon la revendication 10, dans lequel on provoque par irradiation un gonflement de la surface externe dudit diamant, par bombardement ionique ou électronique, pour faire apparaître des éléments interstitiels, des atomes de carbone interstitiels et des lacunes.

12. Procédé de fabrication d'un diamant doté d'une résistance améliorée à la rupture par compression, selon la revendication 10, dans lequel on fait croître le cristal de diamant par processus haute température haute pression et l'on fait encore croître ledit diamant une seconde fois par processus haute température haute pression, en vue de déposer une couche de diamant dopé par des impuretés sur une surface externe.

13. Procédé de fabrication d'un diamant doté d'une résistance améliorée à la rupture par compression, selon la revendication 10, dans lequel lesdites impuretés sont déposées en une couche par croissance hydrothermique, croissance électrochimique, croissance en phase liquide à partir de source solide ou croissance à partir de sel fondu.

**FIGURE 1**

16

FIGURE 2

FIGURE 3

EP 0 892 092 B1

18

# Stresses Generated by an Impurity Concentration Gradient

**FIGURE 4**

# Stresses Generated by an Impurity Concentration Gradient

**FIGURE 5**

# Stresses Generated by an Impurity Shell

**FIGURE 6**

FIGURE 7

FIGURE 8

**FIGURE 9**